# FASCICULE DE BREVET EUROPEEN

(11) **EP 3 408 939 B1**
(45) Date de publication et mention de la délivrance du brevet: **19.02.2020**
(21) Numéro de dépôt: 17707599.1
(22) Date de dépôt: 25.01.2017
(51) Int. Cl.: H02M 1/14, H02P 21/26, H02M 1/44, H03K 7/08

(54) **ÉTALEMENT SPECTRAL POUR MOTEUR ÉLECTRIQUE**
SPEKTRALE VERBREITUNG FÜR EINEN ELEKTROMOTOR
SPECTRAL SPREAD FOR ELECTRIC MOTOR

(30) Priorité: 26.01.2016 FR 1650589
(43) Date de publication de la demande: 05.12.2018
(73) Titulaire: Valeo Systemes Thermiques, 78320 Le Mesnil Saint Denis (FR)
(72) Inventeur: BOURDEL, Philippe, 78322 Le Mesnil Saint-Denis Cedex (FR); GOUMAIN, Xavier, 78322 Le Mesnil Saint-Denis Cedex (FR); FOURNIER, Jonathan, 78322 Le Mesnil Saint-Denis Cedex (FR); GRANDYOT, Sylvain, 78322 Le Mesnil Saint-Denis Cedex (FR)
(74) Mandataire: Metz, Gaëlle
(86) Numéro de dépôt international: PCT/FR2017/050165
(87) Numéro de publication internationale: WO 2017/129902

(56) Documents cités:
- EP-A1- 0 892 498
- WO-A2-2011/001232
- US-A1- 2010 020 573
- US-A1- 2013 200 828

## Description

La description a notamment pour objet un procédé de commande d'un moteur électrique, en particulier un moteur électrique sans balais. Il peut s'agir en particulier d'un moteur électrique sans balais du type de ceux utilisés dans les véhicules automobiles pour entraîner les ventilateurs de l'habitacle desdits véhicules, qui sont typiquement des moteurs synchrones à aimant permanent, et sont souvent triphasés.

Dans un moteur électrique muni de balais, un collecteur tournant assure les commutations nécessaires pour piloter des bobines (formant des électroaimants) via les balais. Les balais posant des problèmes d'entretien et de performance, des moteurs électriques sans balais ont été conçus.

Le pilotage de moteurs électriques sans balais (appelés également moteurs à commutation électronique) implique, en raison de l'absence de balais et de collecteur tournant, un système électronique de commande pour assurer la commutation du courant dans les enroulements (les bobines). Le système électronique de commande comprend usuellement un générateur de signaux électriques. Ces signaux électriques, destinés à transmettre de la puissance au moteur électrique, sont habituellement modulés en largeur d'impulsion (MLI, ou PWM en anglais pour "Pulse Width Modulation"). La MLI consiste à générer un signal logique (0 ou 1) à une période qui peut être fixe mais avec un rapport cyclique variable. La moyenne du signal de sortie est égale au rapport cyclique. En appliquant ainsi une succession d'états discrets pendant des durées bien choisies, on peut obtenir en moyenne sur une certaine durée n'importe quelle valeur intermédiaire.

La MLI est susceptible de poser des problèmes de CEM (compatibilité électromagnétique). En effet, le fait de moduler un signal à une fréquence donnée est susceptible de générer des parasites électromagnétiques en raison de cette fréquence. En particulier, une MLI à période fixe génère des ondes électromagnétiques aux fréquences multiples de la fréquence fondamentale de pilotage de la MLI. On a ainsi pu constater, pour des moteurs de ventilateurs HVAC automobiles pilotés en MLI, des parasites électromagnétiques dans des bandes comprises dans la plage [0 MHz; 1 MHz] et plus particulièrement dans la bande [0 kHz; 125 kHz] (utilisée par des puces RFID associées à certains capteurs) ainsi que dans des bandes des fréquences AM, perturbant la réception d'émissions radiophoniques. HVAC est un acronyme de l'expression anglaise "Heating Ventilation and Air Conditioning" qui désigne le chauffage, la ventilation et la climatisation.

Afin de réduire de tels parasites, une technique d'étalement spectral pour améliorer la CEM a été proposée par la société Valeo (notamment dans sa demande de brevet US20050069301, "Réduction of interference caused by PWM motors"). La MLI peut ainsi être améliorée pour réduire les parasites, notamment dans les fréquences AM et la bande [0 kHz; 125 kHz]. Les fréquences AM sont habituellement susceptibles d'utiliser trois bandes de fréquences. Une première bande dite LW (ondes longues, "long wave" en anglais), une deuxième bande dite MW (ondes moyennes, "médium wave" en anglais) et une troisième bande dite SW (ondes courtes, "short wave" en anglais). Les bandes LW et MW, qui sont les plus susceptibles d'être perturbées, sont comprises entre 150 kHz et 2MHz. La bande [0 kHz; 125 kHz] utilisée par certains capteurs associés à des puces RFID (tels qu'un capteur de pression de pneu) est elle aussi susceptible d'être perturbée. Cependant, cette technique est susceptible d'introduire des parasites acoustiques, dans des fréquences du spectre audible, qui s'étend conventionnellement de 20Hz à 20kHz (même s'il est exceptionnel qu'un humain perçoive la totalité de ce spectre). Le spectre acoustique effectivement audible par un être humain dépend de l'être humain considéré. US 2013/0200828 A1 décrit un système fournissant des signaux de commande PWM pour un circuit inverseur configuré pour alimenter une machine électrique. Ce système comprend un module d'optimisation PWM générant un motif de période pseudo-aléatoire pour réduire le bruit audible.

L'invention vise à améliorer la situation.

L'invention se rapporte notamment à un procédé de commande d'un moteur électrique, comprenant:
une génération, par un circuit électronique de commande, d'un signal électrique de commande du moteur électrique,
ledit signal électrique comprenant une série de séquences d'impulsions,
chaque impulsion de la série de séquences d'impulsions étant définie par sa largeur et par sa période, le rapport de la largeur d'une impulsion sur la période de cette impulsion définissant une puissance électrique moyenne fournie au moteur électrique par cette impulsion,
toutes les séquences d'impulsions de la série de séquences d'impulsions comprenant un nombre identique d'impulsions,
la période d'une impulsion située à une position quelconque d'une séquence d'impulsions de la série de séquences d'impulsions étant égale à la période de l'impulsion située à ladite position de toute autre séquence d'impulsions de la série de séquences d'impulsions,
la période de chaque impulsion d'une séquence d'impulsions de la série de séquences d'impulsions étant fixée de façon pseudo aléatoire, dans une plage de valeurs telle que la période de chaque impulsion d'une séquence d'impulsions a pour borne supérieure l'inverse de 13 kHz,
le nombre d'impulsions de chaque séquence d'impulsions de la série de séquences d'impulsions étant fixé de façon à ce que l'inverse de la somme des périodes de toutes les impulsions de chaque séquence d'impulsions de la série de séquences d'impulsions se situe en dessous du spectre acoustique audible par un être humain.

L'invention se rapporte notamment à un procédé de commande d'un moteur électrique, dans lequel la plage de valeurs dans laquelle est fixée la période de chaque impulsion d'une séquence d'impulsions de la série de séquences d'impulsions a pour borne inférieure l'inverse de 20 kHz.

L'invention se rapporte notamment à un procédé de commande d'un moteur électrique, le moteur électrique étant muni d'un récepteur de mesure, le récepteur de mesure présentant un temps de mesure donné, dans lequel la somme des périodes de toutes les impulsions de chaque séquence d'impulsions de la série de séquences d'impulsions est supérieure ou égale au temps de mesure du récepteur de mesure.

L'invention se rapporte notamment à un procédé de commande d'un moteur électrique, dans lequel chaque séquence d'impulsions de la série de séquences d'impulsions comprend 810 impulsions.

L'invention se rapporte notamment à un procédé de commande d'un moteur électrique, comprenant une génération parallèle de plusieurs signaux électriques de commande du moteur électrique, chaque signal électrique étant généré par un procédé selon l'invention.

L'invention se rapporte notamment à un procédé de commande d'un moteur électrique, comprenant une génération parallèle de six signaux de commande du moteur électrique.

L'invention se rapporte notamment à un circuit électronique de commande d'un moteur électrique, comprenant un générateur de signal électrique de commande du moteur électrique,
ledit signal électrique comprenant une série de séquences d'impulsions,
chaque impulsion de la série de séquences d'impulsions étant définie par sa largeur et par sa période, le rapport de la largeur d'une impulsion sur la période de cette impulsion définissant une puissance électrique moyenne fournie au moteur électrique par cette impulsion,
toutes les séquences d'impulsions de la série de séquences d'impulsions comprenant un nombre identique d'impulsions,
la période d'une impulsion située à une position quelconque d'une séquence d'impulsions de la série de séquences d'impulsions étant égale à la période de l'impulsion située à ladite position de toute autre séquence d'impulsions de la série de séquences d'impulsions,
la période de chaque impulsion d'une séquence d'impulsions de la série de séquences d'impulsions étant fixée de façon pseudo aléatoire, dans une plage de valeurs telle que la période de chaque impulsion d'une séquence d'impulsions de la série de séquences d'impulsions a pour borne supérieure l'inverse de 13 kHz, le nombre d'impulsions de chaque séquence d'impulsions de la série de séquences d'impulsions étant fixé de façon à ce que l'inverse de la somme des périodes de toutes les impulsions de chaque séquence d'impulsions de la série de séquences d'impulsions se situe en dessous du spectre acoustique audible par un être humain.

L'invention se rapporte notamment à un programme d'ordinateur comprenant une série d'instructions qui, lorsqu'elles sont exécutées par un processeur, mettent en œuvre un procédé selon l'invention.

L'invention se rapporte notamment à un support de stockage non transitoire lisible par ordinateur stockant un programme d'ordinateur selon l'invention.

D'autres caractéristiques et avantages de l'invention apparaîtront à la lecture de la description qui va suivre. Celle-ci est purement illustrative et doit être lue en regard des dessins annexés sur lesquels :
- la figure 1 représente de façon schématique les caractéristiques fonctionnelles d'un circuit électronique de commande d'un moteur électrique selon l'état de l'art;
- la figure 2 représente un signal électrique de commande de moteur électrique selon un mode de réalisation de l'invention;
- la figure 3 représente de façon schématique un procédé de commande d'un moteur électrique selon un mode de réalisation de l'invention;
- la figure 4 représente de façon schématique un circuit électronique de commande d'un moteur électrique selon un mode de réalisation de l'invention;
- la figure 5 illustre de façon schématique un circuit électronique de commande d'un moteur électrique selon un autre mode de réalisation de l'invention;
- la figure 6 compare une courbe obtenue à l'aide d'un étalement spectral selon un mode de réalisation de l'invention à une courbe obtenue selon l'état de l'art.

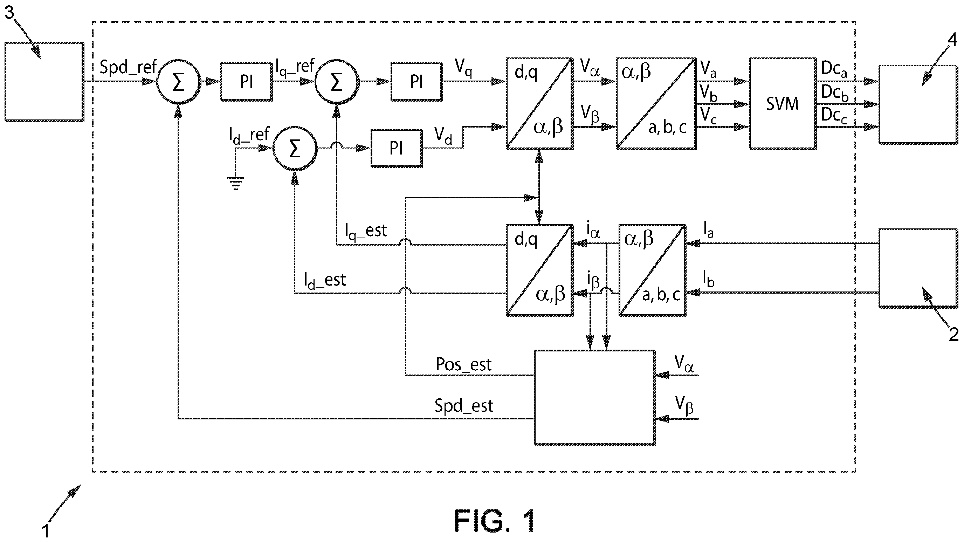

La figure 1 représente de façon schématique les caractéristiques fonctionnelles d'un circuit électronique de commande 1 d'un moteur électrique connu. Le contrôle du moteur synchrone est réalisé par contrôle vectoriel selon une méthode FOC (de l'anglais "Field Oriented Control") qui est bien connue. Pour être capable de réguler la vitesse du moteur, le circuit électronique comprend un logiciel qui réalise l'ensemble des traitements mathématiques représentés par des rectangles sur la figure 1, à intervalles de temps fixes. Dans l'exemple de la figure 1, cet intervalle est de 61 µs. Cet intervalle de temps de 61µs est dicté par les sorties MLI. Ces sorties MLI étant rafraîchies à cette période de 61µs, il est nécessaire de mettre en œuvre une nouvelle commande avant chaque mise à jour des sorties MLI.

Un capteur de courant 2 mesure le courant qui circule dans les phases du stator. La mesure de courant fait l'objet de divers traitements connus (changement de systèmes de coordonnées, estimation du courant dans le rotor, changement de coordonnées dudit courant, etc.).

Une interface 3 de commande de la vitesse du moteur reçoit des consignes de vitesse et les transmet au circuit 1.

Le circuit 1, sur la base d'une part de la position du rotor estimée via les mesures de courant et d'autre part des consignes reçues, envoie un signal de commande à un circuit de pilotage de transistors MOSFET 4.

Le circuit 1 opère à intervalles de temps réguliers de 61µs, ce qui génère des parasites électromagnétiques.

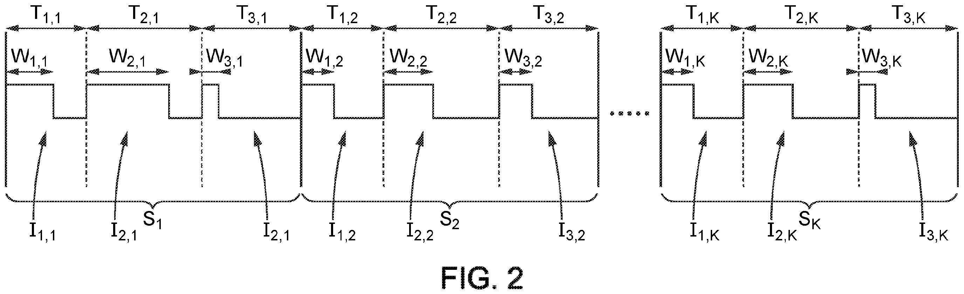

La figure 2 représente un signal électrique de commande de moteur électrique selon un mode de réalisation de l'invention. Le signal représenté est schématique. Il ne comprend que trois impulsions par séquence, ce qui n'est pas réaliste (un nombre de 810 impulsions par séquence serait plus approprié mais n'est pas aisément représentable graphiquement). La figure 2 représente ainsi une série de séquences comprenant au moins trois séquences S₁, S₂ et S_{K} (les séquences intermédiaires entre S₂ et S_{K} ne sont pas représentées). Chaque séquence comporte trois impulsions. La séquence S₁ comprend ainsi trois impulsions I_{1,1}, I_{2,1} et I_{3,1}, la séquence S₂ comprend trois impulsions I_{1,2}, I_{2,2} et I_{3,2}, et la séquence S_{K} comprend trois impulsions I_{1,K}, I_{2,K} et I_{3,K}. Chaque impulsion I_{i,j} est caractérisée par sa largeur W_{i,j} et par sa période T_{i,j}, i étant compris entre 1 et 3 et j étant compris entre 1 et l'infini (K étant la dernière valeur représentée, mais le moteur peut tourner sans limitation de durée, tant qu'il n'est pas usé).

On observe la périodicité des périodes T_{i,j}. On constate ainsi que T_{1,1}=T_{1,2}=T_{1,K}, que T_{2,1}=T_{2,2}=T_{2,K}, et que T_{3,1}=T_{3,2}=T_{3,K}. En revanche, l'information modulée (définie pour chaque impulsion I_{i,j} par le rapport cyclique W_{i,j}/T_{i,j}) ne présente pas de périodicité particulière.

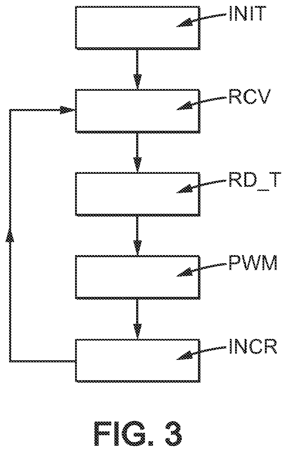

La figure 3 représente de façon schématique un procédé de commande d'un moteur électrique selon un mode de réalisation de l'invention.

Le procédé comprend tout d'abord une étape d'initialisation INIT. Cette étape peut être mise en œuvre notamment lors de la mise sous tension du moteur, ou en cas de redémarrage. Lors de cette initialisation, le procédé peut générer une table de périodes aléatoires pour une séquence d'impulsions de référence. Dans le cas représenté sur la figure 2, ceci reviendrait à générer trois nombres aléatoires, R₁, R₂ et R₃, avec R₁=T_{1,1}=T_{1,2}= T_{1,K}, R₂=T_{2,1}=T_{2,2}=T_{2,K} et R₃=T_{3,1}=T_{3,2}=T_{3,K}. Mais ces nombres aléatoires peuvent alternativement avoir été générés préalablement et avoir été stockés par exemple dans une mémoire ROM installée dans le moteur électrique lors de sa fabrication. L'étape d'initialisation comprend également l'initialisation d'un compteur i, par exemple à zéro (qui est une valeur arbitraire choisie pour sa simplicité, mais d'autres valeurs sont possibles, à condition de modifier l'algorithme en conséquence).

Le procédé débute alors une boucle infinie commençant par une étape RCV de réception d'une consigne de commande moteur.

Vient alors une étape RD_T de lecture d'une période dans la table des périodes aléatoires, à l'index i+1. Lors du premier passage, le procédé lit donc la valeur R₁=T_{1,1}=T_{1,2}=T_{1,K}.

Cette étape est suivie d'une étape PWM de génération d'une impulsion modulée en largeur d'impulsion, au cours de laquelle le procédé détermine, en fonction de la consigne reçue à l'étape RCV et de la période courante lue à l'étape RD_T, la largeur de l'impulsion. Dans un scénario simple, la consigne précise directement le rapport cyclique désiré. Le procédé se contente alors de multiplier le rapport cyclique reçu à l'étape RCV par la période à utiliser, lue dans la table à l'étape RD_T. D'autres moyens de calcul sont possibles. Le procédé génère alors l'impulsion qu'il a déterminée à destination d'un transistor de puissance, via le cas échéant un circuit de pilotage de transistor.

Vient alors une étape INCR d'incrémentation modulaire de l'index i. Le procédé calcule i=i+1 mod N, N désignant le nombre d'impulsions par séquence (N=3 sur la figure 2). La procédure itérative se répète alors à l'infini en retournant à l'étape RCV.

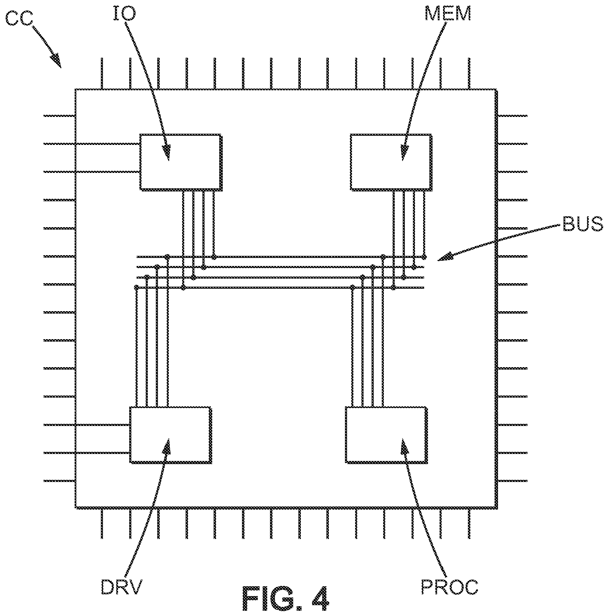

La figure 4 représente de façon schématique un circuit électronique de commande d'un moteur électrique selon un mode de réalisation de l'invention. Le circuit électronique comprend dans un même boîtier un microprocesseur PROC et une mémoire MEM stockant un programme d'ordinateur selon un mode de réalisation de l'invention. Le circuit électronique comprend également dans ce même boîtier une interface d'entrées sorties IO pour recevoir des consignes de commande moteur, ainsi qu'un circuit pilote DRV de transistors de puissance. Le processeur PROC, la mémoire MEM, le circuit d'entrées sorties IO et le circuit pilote DRV sont reliés par un bus BUS interne au boîtier. Le circuit d'entrées sorties IO et le circuit pilote DRV sont chacun connectés à des broches du boîtier, ce qui permet une interconnexion du boîtier avec le monde extérieur.

Lorsqu'il exécute le programme stocké dans la mémoire MEM (qui est par exemple une mémoire de type ROM, acronyme provenant de l'anglais "Read Only Memory" traduit en français par "mémoire morte"), le processeur PROC est conduit à recevoir périodiquement des consignes via l'interface d'entrées sorties IO, et en fonction de ces consignes, il envoie un signal de commande selon l'invention via le circuit pilote DRV à des transistors de puissance pour commander le fonctionnement du moteur électrique.

Selon une variante possible, la mémoire précitée est intégrée avec le processeur précité, au sein d'un microcontrôleur. Selon une mise en œuvre possible de cette variante, au lieu d'un boîtier on prévoit deux boîtiers dont l'un comprend le microcontrôleur et l'autre comprend le circuit pilote DRV (pour piloter des transistors MOSFET contrôlant le moteur électrique).

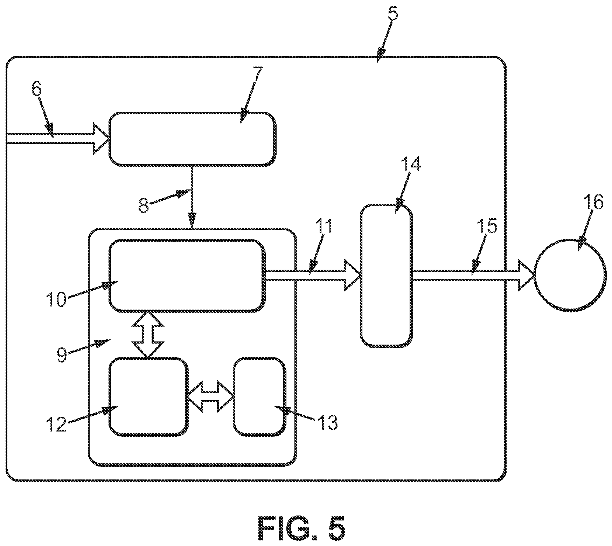

La figure 5 représente un mode de réalisation dans lequel un circuit de commande 5 reçoit une commande externe 6 via une interface d'entrées-sorties 7. Cette interface 7 envoie alors une commande interne 8 à un microcontrôleur 9. La commande interne 8 est reçue par une interface d'entrées-sorties 10 du microcontrôleur. Cette interface 10 est agencée pour émettre des commandes 11 permettant de contrôler une modulation de largeur d'impulsion (MLI) définissant un signal qui pilote un moteur électrique. L'interface 10 communique avec une mémoire 12 (telle qu'une mémoire morte) du microcontrôleur 9, mémoire comprenant un programme d'ordinateur. Cette mémoire 12 communique elle-même avec un processeur 13 du microcontrôleur. Ce processeur 13 est agencé pour exécuter un programme d'ordinateur stocké dans la mémoire 12. Les commandes 11 émises par l'interface 10 sont reçues par un circuit pilote 14, qui émet des commandes moteur 15 à destination d'un moteur électrique 16.

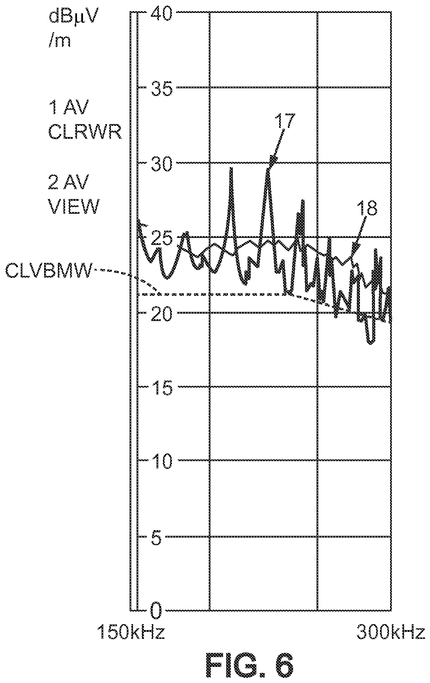

La figure 6 illustre deux courbes, l'une illustrant les émissions parasites mesurées avec un procédé de commande selon l'état de l'art, l'autre illustrant les émissions parasites mesurées avec un procédé de commande selon un mode de réalisation de l'invention. On observe que la courbe 17, obtenue avec un procédé selon l'état de l'art comprenant un découpage à 16,4 kHz, présente des harmoniques de 16,4 kHz, atteignant quasiment (pour deux d'entre elles) 30 dBµV. A contrario, dans la courbe 18, obtenue selon un mode de réalisation, l'étalement spectral mis en œuvre fait disparaître les harmoniques.

Un premier mode de réalisation se rapporte à un procédé de commande d'un moteur électrique. Le moteur électrique est par exemple moteur PMSM (de l'anglais "permanent-magnet synchronous motor", moteur synchrone à aimants permanents). Il peut être dénué de capteurs de position (et estimer la position du rotor de façon algorithmique, par exemple sur la base de mesures de courants). Il est par exemple triphasé. Il est par exemple muni de quatre paires de pôles. Il s'agit par exemple d'un moteur de 325W (26A sur 12,5V). Un tel moteur est adapté par exemple pour animer un ventilateur d'habitacle de véhicule automobile.

Le procédé comprend une génération, par un circuit électronique de commande, d'un signal électrique de commande du moteur électrique. Selon une mise en œuvre possible, le circuit électronique de commande est formé d'un composant unique. Selon une mise en œuvre possible, le circuit électronique de commande est formé d'un ensemble de composants. Selon une mise en œuvre possible, le circuit électronique de commande est un circuit électronique programmable, par exemple de type FPGA. Selon une mise en œuvre possible, le circuit électronique de commande comprend un processeur (tel qu'un DSP) et une mémoire contenant un programme qui, lorsqu'il est exécuté par le processeur, conduit le processeur à mettre en œuvre les fonctions du circuit électronique de commande selon l'invention. Cette dernière mise en œuvre est avantageuse en ce qu'elle permet de mettre en œuvre l'invention dans certains moteurs de l'état de l'art simplement en chargeant un nouveau programme d'ordinateur dans la mémoire de ce moteur.

Le signal électrique de commande est par exemple un signal MLI.

Le signal électrique de commande commande par exemple un transistor de puissance (tel qu'un transistor MOSFET de puissance) permettant de délivrer de la puissance électrique au moteur lorsque le signal électrique de commande est au niveau logique 1 (qui selon une mise en œuvre possible correspond à un niveau physique de 12V) et de ne pas en délivrer lorsque le signal électrique de commande est au niveau logique 0.

Le signal électrique de commande comprend une série de séquences d'impulsions.

Chaque impulsion comprend une portion de signal durant laquelle le signal est au niveau logique 1 et une portion de signal durant laquelle le signal est au niveau logique 0. Selon une mise en œuvre possible, chaque impulsion consiste en une portion de signal logique 1 durant une certaine durée suivie par une portion de signal logique 0 durant une autre durée. Selon une mise en œuvre possible, chaque impulsion consiste en une portion de signal logique 0 durant une certaine durée suivie par une portion de signal logique 1 durant une autre durée. Selon une mise en œuvre possible, toutes les impulsions du signal électrique de commande consistent chacune en une portion de signal logique 1 durant une certaine durée suivie par une portion de signal logique 0 durant une autre durée. Selon une mise en œuvre possible, toutes les impulsions du signal électrique de commande consistent chacune en une portion de signal logique 0 durant une certaine durée suivie par une portion de signal logique 1 durant une autre durée.

Chaque impulsion de la série de séquences d'impulsions est définie par sa largeur et par sa période. La largeur de l'impulsion peut être définie comme la durée pendant laquelle la portion de signal représentant l'impulsion reste au niveau logique 1. La durée de l'impulsion peut être définie comme la durée totale de la portion de signal représentant l'impulsion, qui est la durée séparant le début de l'impulsion du début de l'impulsion suivante.

Le rapport de la largeur d'une impulsion sur la période de cette impulsion (appelé rapport cyclique) définit une puissance électrique moyenne fournie au moteur électrique par cette impulsion. Plus précisément, cette puissance électrique moyenne est proportionnelle à ce rapport cyclique. Plus le rapport cyclique est élevé, c'est-à-dire plus la largeur de l'impulsion est proche de la durée de l'impulsion, plus l'impulsion délivre de puissance au moteur.

Toutes les séquences d'impulsions de la série de séquences d'impulsions comprennent un nombre identique d'impulsions. Par exemple, chaque séquence d'impulsions comprend N=810 impulsions.

La période T_{i,j} d'une impulsion I_{i,j} située à une position quelconque Pᵢ d'une séquence d'impulsions Sⱼ = {I_{1,j}; I_{2,j}; ... I_{i,j}; ... I_{N,j}} de la série de séquences d'impulsions est égale à la période T_{i,k} de l'impulsion I_{i,k} située à ladite position Pᵢ de toute autre séquence d'impulsions Sₖ = {I_{1,k}; I_{2,k}; ... I_{i,k}; ... I_{N,k}} de la série de séquences d'impulsions. On a ainsi T_{i,j}=T_{i,K} pour tout triplet {i,j,k}.

La période de chaque impulsion d'une séquence d'impulsions de la série de séquences d'impulsions est fixée de façon pseudo aléatoire. Selon une mise en œuvre possible, la fixation pseudo aléatoire des périodes précitées est opérée préalablement, par exemple lors de la fabrication du moteur (le procédé n'a donc pas à générer ces périodes aléatoires). Selon une autre mise en œuvre, le procédé est agencé pour générer lui-même les périodes aléatoires requises, ce qu'il peut effectuer par exemple lors d'une phase d'initialisation (par exemple à chaque fois que le moteur est mis sous tension).

Ainsi, en reprenant les notations ci-dessus, T_{i1,j} est la plupart du temps différent de T_{i2,j} quel que soit j, si i1 est différent de i2, car la probabilité que deux valeurs pseudo aléatoires soient égales est faible. Ce caractère pseudo-aléatoire implique un étalement spectral qui permet d'éviter de générer des parasites à une fréquence égale à l'inverse de la période fixe (dans le cas où la période est fixe au lieu d'être pseudo aléatoire), ainsi qu'aux multiples de cette fréquence. Ces parasites proviennent de la commutation des transistors MOSFET de l'état passant à l'état bloqué (ou vice-versa), pilotés par les impulsions. Ces parasites peuvent comprendre des harmoniques du découpage généré(e)s par les transistors MOSFET. Mais il convient également d'éviter des parasites acoustiques.

La période de chaque impulsion d'une séquence d'impulsions de la série de séquences d'impulsions est fixée de façon pseudo aléatoire dans une plage de valeurs telle que l'inverse de la période ainsi fixée de façon pseudo aléatoire se situe au-dessus du spectre acoustique audible par un être humain (ou dans le haut du spectre acoustique). Par "au-dessus du spectre acoustique audible par un être humain" on entend que l'inverse de la période fixée de façon pseudo aléatoire est supérieur à la borne supérieure du spectre acoustique audible par un être humain. Selon une mise en œuvre possible, l'inverse de la période fixée de façon pseudo aléatoire est supérieur à 20kHz, mais selon une variante, il peut être supérieur à une fréquence plus faible que 20kHz. Le spectre acoustique se termine conventionnellement à 20kHz (c'est sa borne haute), mais cette fréquence de 20kHz n'est pas audible par la plupart des êtres humains. Selon une mise en œuvre possible, le haut du spectre acoustique est défini comme la plage de fréquences de 13kHz à 19 kHz. Des plages alternatives intermédiaires sont possibles (par exemple de 15kHz à 20kHz). Le haut du spectre acoustique est considéré comme supérieur (en fréquence) au spectre acoustique audible par un être humain.

Le nombre ne d'impulsions de chaque séquence d'impulsions de la série de séquences d'impulsions est fixé de façon à ce que l'inverse de la somme des périodes de toutes les impulsions de chaque séquence d'impulsions de la série de séquences d'impulsions se situe en dessous du spectre acoustique audible par un être humain (ou dans le bas du spectre acoustique). Par "en dessous du spectre acoustique audible par un être humain" on entend que l'inverse de la somme des périodes précitées est inférieur à la borne inférieure du spectre acoustique audible par un être humain. Selon une variante, l'inverse de la somme des périodes précitées est inférieur à 20Hz. Le spectre acoustique commence conventionnellement à 20Hz, mais cette fréquence de 20Hz n'est pas audible par de nombreux êtres humains qui distinguent souvent mal les fréquences inférieures à 50Hz. Selon une mise en œuvre possible, le bas du spectre acoustique est défini comme la plage de fréquences de 20Hz à 50Hz. Des plages alternatives intermédiaires sont possibles (par exemple de 20hz à 35Hz). Le bas du spectre acoustique est considéré comme inférieur (en fréquence) au spectre acoustique audible par un être humain.

Le procédé selon le premier mode de réalisation permet de gagner 3 à 5 dB dans la bande LW (première bande de la modulation AM, comprise entre 150 kHz et 300 kHz, comme illustré sur la figure 6), sans dégrader les performances acoustiques.

Un deuxième mode de réalisation concerne un procédé de commande d'un moteur électrique selon le premier mode de réalisation, dans lequel la plage de valeurs dans laquelle est fixée la période de chaque impulsion d'une séquence d'impulsions de la série de séquences d'impulsions a pour borne supérieure l'inverse de 13kHz. Ceci permet de réduire les parasites audibles, pour la plupart des personnes.

Un troisième mode de réalisation se rapporte à un procédé de commande d'un moteur électrique selon le premier ou le deuxième mode de réalisation, dans lequel la plage de valeurs dans laquelle est fixée la période de chaque impulsion d'une séquence d'impulsions de la série de séquences d'impulsions a pour borne inférieure l'inverse de 19kHz. Cette limite inférieure est avantageuse, car elle correspond à la limite de la puissance de calcul disponible dans des microcontrôleurs de contrôle de moteurs de l'état de l'art. De tels microcontrôleurs ont en général des fonctions autres que le contrôle moteur, fonctions qui consomment également une partie de leur puissance de calcul. Au-delà de 19kHz, les contraintes temps réel sont donc habituellement plus difficiles à respecter.

Un quatrième mode de réalisation se rapporte à un procédé de commande d'un moteur électrique selon l'un des premier au troisième modes de réalisation. Le moteur électrique est muni d'un récepteur de mesure, le récepteur de mesure présentant un temps de mesure donné. La somme des périodes de toutes les impulsions de chaque séquence d'impulsions de la série de séquences d'impulsions est supérieure ou égale à ce temps de mesure, qui est typiquement proche de 50ms (ce qui correspond également à la limite basse du spectre acoustique). Ceci est avantageux, car les séquences d'impulsions ont toutes une structure semblable. Plus précisément, les périodes des impulsions contenues dans deux séquences quelconques sont toujours les mêmes (comme exposé précédemment, T_{i,j}=T_{i,k} pour tout triplet {i,j,k}). Les rapports cycliques de chaque impulsion sont certes susceptibles d'être différents, mais il ressort néanmoins de chaque séquence des éléments périodiques (que l'on retrouve dans chaque séquence), susceptibles de créer des parasites à leur fréquence d'apparition et aux multiples de cette fréquence. En employant des séquences de longueur supérieure ou égale à 50ms, le procédé assure que la fréquence d'apparition des éléments périodiques (dont la périodicité est liée à la structure identique des séquences) est inférieure à 1/(50^{∗}10⁻³s) = 20Hz. Or une fréquence inférieure à 20Hz est en dehors du spectre acoustique audible par un être humain.

Selon un cinquième mode de réalisation, chaque séquence d'impulsions de la série de séquences d'impulsions d'un procédé de commande d'un moteur électrique selon le quatrième mode de réalisation comprend 810 impulsions. Ce nombre d'impulsions résulte du rapport de la durée de la séquence par la période moyenne d'une impulsion. Ainsi, pour une durée de séquence de 50ms (qui peut être choisie pour éviter des parasites audibles en bas du spectre acoustique et qui correspond également au temps de mesure typique des récepteurs de mesure classiques) et pour des impulsions d'une fréquence moyenne de 16,2kHz (afin également d'éviter des parasites audibles, car les humains ne perçoivent habituellement pas une telle fréquence bien qu'elle se situe dans le spectre acoustique), on a 50^{∗}16,2=810 impulsions par séquence. La période de chacune de ces 810 impulsions pourrait être générée aléatoirement à la volée, mais ce serait souvent trop pénalisant du point de vue de la puissance de calcul disponible. Il est donc avantageux d'utiliser des périodes aléatoires prédéfinies.

Selon une mise en œuvre possible, dans une phase d'initialisation, le procédé génère aléatoirement 810 valeurs de périodes d'impulsions telles que l'inverse de chacune de ces valeurs se trouve au-dessus du spectre acoustique audible par un être humain (par exemple au-dessus de 13kHz si l'on admet que peu de personnes perçoivent des fréquences supérieures à 13kHz), et telle que la somme de ces valeurs soit sensiblement égale à 50ms. Selon une mise en œuvre possible, ces 810 valeurs sont alors stockées dans une table. En fonctionnement, le procédé consulte alors la table lorsqu'il a besoin de connaître la période de l'impulsion suivante qu'il doit générer. Le procédé peut ainsi maintenir un compteur d'éléments contenus dans la table. Selon une mise en œuvre possible, il incrémente ce compteur modulo la taille de la table (ce qui introduit la périodicité désirée, chaque séquence correspondant à un parcours complet de la table). Selon une autre variante, au lieu de stocker les 810 valeurs (ou tout autre nombre approprié de valeurs) dans une table (au sein d'une mémoire qui peut être une mémoire non volatile, notamment de type ROM, EEPROM ou Flash), le procédé génère, toujours au cours d'une phase d'initialisation, une machine d'états qui mémorise les 810 valeurs et fait passer de chaque valeur à la valeur suivante. Au lieu de recourir à une phase d'initialisation, le procédé peut s'appuyer sur des paramètres prédéfinis en usine lors de la fabrication d'un circuit électronique de commande d'un moteur électrique agencé pour mettre en œuvre le procédé.

Selon un sixième mode de réalisation, un procédé de commande d'un moteur électrique comprend une génération parallèle de plusieurs signaux électriques de commande du moteur électrique, chaque signal électrique étant généré par un procédé selon l'un des premier au cinquième modes de réalisation.

Selon un septième mode de réalisation, un procédé de commande d'un moteur électrique selon le sixième mode de réalisation comprend une génération parallèle de six signaux de commande du moteur électrique. Ainsi, chacun des signaux parallèles peut par exemple commander un transistor de puissance distinct afin de piloter le moteur électrique. Le procédé peut donc commander six transistors, chacun avec un signal électrique de commande qui lui est propre. Chacun des six signaux est construit selon un schéma de commutation permettant de piloter les phases du moteur, ce qui fait tourner le moteur.

Selon un huitième mode de réalisation, un circuit électronique de commande d'un moteur électrique comprend un générateur de signal électrique de commande du moteur électrique. Ce générateur est donc un sous-ensemble du circuit électronique de commande. Mais selon une variante, le générateur constitue le circuit électronique de commande. Selon une mise en œuvre possible, le générateur est formé d'un composant unique. Selon une mise en œuvre possible, le générateur est formé d'un ensemble de composants. Selon une mise en œuvre possible, le générateur est un circuit électronique programmable, par exemple de type FPGA. Selon une mise en œuvre possible, le générateur comprend un processeur (tel qu'un DSP) et une mémoire contenant un programme qui, lorsqu'il est exécuté par le processeur, conduit le processeur à mettre en œuvre les fonctions du générateur selon l'invention.

Le signal électrique de commande comprend une série de séquences d'impulsions.

Chaque impulsion de la série de séquences d'impulsions est définie par sa largeur et par sa période.

Le rapport de la largeur d'une impulsion sur la période de cette impulsion définit une puissance électrique moyenne fournie au moteur électrique par cette impulsion.

Toutes les séquences d'impulsions de la série de séquences d'impulsions comprennent un nombre identique d'impulsions.

La période d'une impulsion située à une position quelconque d'une séquence d'impulsions de la série de séquences d'impulsions est égale à la période de l'impulsion située à ladite position de toute autre séquence d'impulsions de la série de séquences d'impulsions.

La période de chaque impulsion d'une séquence d'impulsions de la série de séquences d'impulsions est fixée de façon pseudo aléatoire, dans une plage de valeurs telle que l'inverse de la période ainsi fixée de façon pseudo aléatoire se situe au-dessus du spectre acoustique audible par un être humain.

Le nombre d'impulsions de chaque séquence d'impulsions de la série de séquences d'impulsions est fixé de façon à ce que l'inverse de la somme des périodes de toutes les impulsions de chaque séquence d'impulsions de la série de séquences d'impulsions se situe en dessous du spectre acoustique audible par un être humain.

Les caractéristiques des premier au septième modes de réalisation se rapportant à un procédé de commande d'un moteur électrique sont transposables au circuit électronique de commande d'un moteur électrique selon le huitième mode de réalisation, et réciproquement.

Selon un neuvième mode de réalisation, un programme d'ordinateur comprend une série d'instructions qui, lorsqu'elles sont exécutées par un processeur, mettent en œuvre un procédé selon l'un des premiers au septième modes de réalisation. Le programme d'ordinateur peut notamment être conçu en langage assembleur, ou en langage bas niveau tel que le langage C.

Selon un dixième mode de réalisation, un support de stockage non transitoire lisible par ordinateur stocke un programme d'ordinateur selon le neuvième mode de réalisation. Le support de stockage est par exemple une mémoire non volatile, telle qu'une mémoire Flash, EEPROM, ROM, etc.

## Revendications

1. Procédé de commande d'un moteur électrique, comprenant:
une génération, par un circuit électronique de commande, d'un signal électrique de commande du moteur électrique,
le signal électrique de commande comprenant une série de séquences (S₁, S₂, S_{N}) d'impulsions,
chaque impulsion (I_{1,1}; ... I_{3,N}) de la série de séquences d'impulsions étant définie par sa largeur (W_{1,1}; ... W_{3,N}) et par sa période (T_{1,1}; ... T_{3,N}),
le rapport de la largeur d'une impulsion sur la période de cette impulsion définissant une puissance électrique moyenne fournie au moteur électrique par cette impulsion,
toutes les séquences d'impulsions de la série de séquences d'impulsions comprenant un nombre identique d'impulsions,
la période (T_{1,1}) d'une impulsion située à une position quelconque d'une séquence d'impulsions de la série de séquences d'impulsions étant égale à la période (T_{1,2}; T_{1,N}) de l'impulsion située à ladite position de toute autre séquence d'impulsions de la série de séquences d'impulsions,
la période de chaque impulsion d'une séquence d'impulsions de la série de séquences d'impulsions étant fixée de façon pseudo aléatoire, dans une plage de valeurs telle que la période de chaque impulsion d'une séquence d'impulsions de la série de séquences d'impulsions a pour borne supérieure l'inverse de 13 kHz,
le nombre d'impulsions de chaque séquence d'impulsions de la série de séquences d'impulsions étant fixé de façon à ce que l'inverse de la somme des périodes de toutes les impulsions de chaque séquence d'impulsions de la série de séquences d'impulsions se situe en dessous du spectre acoustique audible par un être humain.

2. Procédé de commande d'un moteur électrique selon la revendication 1, dans lequel la plage de valeurs dans laquelle est fixée la période de chaque impulsion d'une séquence d'impulsions de la série de séquences d'impulsions a pour borne inférieure l'inverse de 19kHz.

3. Procédé de commande d'un moteur électrique selon l'une des revendications précédentes, le moteur électrique étant muni d'un récepteur de mesure, le récepteur de mesure présentant un temps de mesure donné, dans lequel la somme des périodes de toutes les impulsions de chaque séquence d'impulsions de la série de séquences d'impulsions est supérieure ou égale au temps de mesure du récepteur de mesure.

4. Procédé de commande d'un moteur électrique selon la revendication 3, dans lequel chaque séquence d'impulsions de la série de séquences d'impulsions comprend 810 impulsions.

5. Procédé de commande d'un moteur électrique, comprenant une génération parallèle de plusieurs signaux électriques de commande du moteur électrique, chaque signal électrique étant généré par un procédé selon l'une des revendications précédentes.

6. Procédé de commande d'un moteur électrique selon la revendication 5, comprenant une génération parallèle de six signaux de commande du moteur électrique.

7. Circuit (CC) électronique de commande d'un moteur électrique, comprenant un générateur de signal électrique de commande du moteur électrique,
ledit signal électrique comprenant une série de séquences (S₁, S₂, S_{N}) d'impulsions,
chaque impulsion (I_{1,1}; ... I_{3,N}) de la série de séquences d'impulsions étant définie par sa largeur (W_{1,1}; ... W_{3,N}) et par sa période (T_{1,1}; ... T_{3,N}), le rapport de la largeur d'une impulsion sur la période de cette impulsion définissant une puissance électrique moyenne fournie au moteur électrique par cette impulsion,
toutes les séquences d'impulsions de la série de séquences d'impulsions comprenant un nombre identique d'impulsions,
la période (T_{1,1}) d'une impulsion située à une position quelconque d'une séquence d'impulsions de la série de séquences d'impulsions étant égale à la période (T_{1,2}; T_{1,N}) de l'impulsion située à ladite position de toute autre séquence d'impulsions de la série de séquences d'impulsions,
la période de chaque impulsion d'une séquence d'impulsions de la série de séquences d'impulsions étant fixée de façon pseudo aléatoire, dans une plage de valeurs telle que la période de chaque impulsion d'une séquence d'impulsions de la série de séquences d'impulsions a pour borne supérieure l'inverse de 13 kHz, le nombre d'impulsions de chaque séquence d'impulsions de la série de séquences d'impulsions étant fixé de façon à ce que l'inverse de la somme des périodes de toutes les impulsions de chaque séquence d'impulsions de la série de séquences d'impulsions se situe en dessous du spectre acoustique audible par un être humain.

8. Programme d'ordinateur comprenant une série d'instructions qui, lorsqu'elles sont exécutées par un processeur, mettent en œuvre un procédé selon l'une des revendications 1 à 6.

9. Support de stockage non transitoire lisible par ordinateur stockant un programme d'ordinateur selon la revendication 8.

## Patentansprüche

1. Verfahren zur Steuerung eines Elektromotors, das enthält:
eine Erzeugung eines elektrischen Steuersignals des Elektromotors durch einen elektronischen Steuerkreis,
wobei das elektrische Steuersignal eine Reihe von Impulsfolgen (S₁, S₂, S_{N}) enthält,
wobei jeder Impuls (I_{1,1}; ... I_{3,N}) der Reihe von Impulsfolgen durch seine Breite (W_{1,1}; ... W_{3,N}) und durch seine Periode (T_{1,1}; ... T_{3,N}) definiert wird,
wobei das Verhältnis der Breite eines Impulses zur Periode dieses Impulses eine mittlere elektrische Leistung definiert, die von diesem Impuls an den Elektromotor geliefert wird,
wobei alle Impulsfolgen der Reihe von Impulsfolgen eine gleiche Anzahl von Impulsen enthalten,
wobei die Periode (T_{1,1}) eines Impulses, der sich an einer beliebigen Stelle einer Impulsfolge der Reihe von Impulsfolgen befindet, gleich der Periode (T_{1,2}; T_{1,N}) des Impulses ist, der sich an dieser Stelle jeder anderen Impulsfolge der Reihe von Impulsfolgen befindet,
wobei die Periode jedes Impulses einer Impulsfolge der Reihe von Impulsfolgen pseudo-zufällig in einem derartigen Wertebereich festgelegt wird, dass die Periode jedes Impulses einer Impulsfolge der Reihe von Impulsfolgen als Obergrenze den Kehrwert von 13 kHz hat,
wobei die Anzahl von Impulsen jeder Impulsfolge der Reihe von Impulsfolgen so festgelegt wird, dass der Kehrwert der Summe der Perioden aller Impulse jeder Impulsfolge der Reihe von Impulsfolgen sich unterhalb des für einen Menschen hörbaren akustischen Spektrums befindet.

2. Steuerverfahren eines Elektromotors nach Anspruch 1, wobei der Wertebereich, in dem die Periode jedes Impulses einer Impulsfolge der Reihe von Impulsfolgen festgelegt wird, als Untergrenze den Kehrwert von 19 kHz hat.

3. Steuerverfahren eines Elektromotors nach einem der vorhergehenden Ansprüche, wobei der Elektromotor mit einem Messempfänger versehen ist, wobei der Messempfänger eine gegebene Messzeit aufweist, wobei die Summe der Perioden aller Impulse jeder Impulsfolge der Reihe von Impulsfolgen größer als die oder gleich der Messzeit des Messempfängers ist.

4. Steuerverfahren eines Elektromotors nach Anspruch 3, wobei jede Impulsfolge der Reihe von Impulsfolgen 810 Impulse enthält.

5. Steuerverfahren eines Elektromotors, das eine parallele Erzeugung mehrerer elektrischer Steuersignale des Elektromotors enthält, wobei jedes elektrische Signal durch ein Verfahren nach einem der vorhergehenden Ansprüche erzeugt wird.

6. Steuerverfahren eines Elektromotors nach Anspruch 5, das eine parallele Erzeugung von sechs Steuersignalen des Elektromotors enthält.

7. Elektronischer Steuerkreis (CC) eines Elektromotors, der einen Erzeuger eines elektrischen Steuersignals des Elektromotors enthält,
wobei das elektrische Signal eine Reihe von Impulsfolgen (S₁, S₂, S_{N}) enthält,
wobei jeder Impuls (I_{1,1}; ... I_{3,N}) der Reihe von Impulsfolgen durch seine Breite (W_{1,1}; ... W_{3,N}) und durch seine Periode (T_{1,1}; ... T_{3,N}) definiert wird,
wobei das Verhältnis der Breite eines Impulses zur Periode dieses Impulses eine mittlere elektrische Leistung definiert, die von diesem Impuls an den Elektromotor geliefert wird,
wobei alle Impulsfolgen der Reihe von Impulsfolgen eine gleiche Anzahl von Impulsen enthalten,
wobei die Periode (T_{1,1}) eines Impulses, der sich an einer beliebigen Stelle einer Impulsfolge der Reihe von Impulsfolgen befindet, gleich der Periode (T_{1,2}; T_{1,N}) des Impulses ist, der sich an dieser Stelle jeder anderen Impulsfolge der Reihe von Impulsfolgen befindet,
wobei die Periode jedes Impulses einer Impulsfolge der Reihe von Impulsfolgen pseudo-zufällig in einem derartigen Wertebereich festgelegt wird, dass die Periode jedes Impulses einer Impulsfolge der Reihe von Impulsfolgen als Obergrenze den Kehrwert von 13 kHz hat,
wobei die Anzahl von Impulsen jeder Impulsfolge der Reihe von Impulsfolgen so festgelegt wird, dass der Kehrwert der Summe der Perioden aller Impulse jeder Impulsfolge der Reihe von Impulsfolgen sich unterhalb des für einen Menschen hörbaren akustischen Spektrums befindet.

8. Computerprogramm, das eine Reihe von Anweisungen enthält, die, wenn sie von einem Prozessor ausgeführt werden, ein Verfahren nach einem der Ansprüche 1 bis 6 durchführen.

9. Computerlesbarer Träger zur dauerhaften Speicherung, der ein Computerprogramm nach Anspruch 8 speichert.

## Claims

1. Method of control of an electric motor, comprising:
generation, by an electronic control circuit, of an electrical control signal for the electric motor,
the electrical control signal comprising a series of sequences (S₁, S₂, S_{N}) of pulses,
each pulse (I_{1,1}; ... I_{3,N}) of the series of sequences of pulses being defined by its width (W_{1,1}; ... W_{3,N}) and by its period (T_{1,1}; ... T_{3,N}), the ratio of the width of a pulse to the period of this pulse defining a mean electrical power provided to the electric motor by this pulse,
all the sequences of pulses of the series of sequences of pulses comprising an identical number of pulses,
the period (T_{1,1}) of a pulse situated at an arbitrary position of a sequence of pulses of the series of sequences of pulses being equal to the period (T_{1,2}; T_{1,N}) of the pulse situated at said position of any other sequence of pulses of the series of sequences of pulses, the period of each pulse of a sequence of pulses of the series of sequences of pulses being fixed in a pseudorandom manner, in a range of values such that the period of each pulse of a sequence of pulses of the series of sequences of pulses has as upper bound the inverse of 13 kHz,
the number of pulses of each sequence of pulses of the series of sequences of pulses being fixed in such a way that the inverse of the sum of the periods of all the pulses of each sequence of pulses of the series of sequences of pulses lies below the acoustic spectrum audible to a human being.

2. Method of control of an electric motor according to Claim 1, in which the range of values in which the period of each pulse of a sequence of pulses of the series of sequences of pulses is fixed has as lower bound the inverse of 19 kHz.

3. Method of control of an electric motor according to either of the preceding claims, the electric motor being furnished with a measurement receiver, the measurement receiver exhibiting a given measurement time, in which the sum of the periods of all the pulses of each sequence of pulses of the series of sequences of pulses is greater than or equal to the measurement time of the measurement receiver.

4. Method of control of an electric motor according to Claim 3, in which each sequence of pulses of the series of sequences of pulses comprises 810 pulses.

5. Method of control of an electric motor, comprising a parallel generation of several electrical control signals for the electric motor, each electrical signal being generated by a method according to one of the preceding claims.

6. Method of control of an electric motor according to Claim 5, comprising a parallel generation of six control signals for the electric motor.

7. Electronic circuit (CC) for control of an electric motor, comprising an electrical control signal generator for the electric motor,
said electrical signal comprising a series of sequences (S₁, S₂, S_{N}) of pulses,
each pulse (I_{1,1}; ... I_{3,N}) of the series of sequences of pulses being defined by its width (W_{1,1}; ... W_{3,N}) and by its period (T_{1,1}; ... T_{3,N}), the ratio of the width of a pulse to the period of this pulse defining a mean electrical power provided to the electric motor by this pulse,
all the sequences of pulses of the series of sequences of pulses comprising an identical number of pulses,
the period (T_{1,1}) of a pulse situated at an arbitrary position of a sequence of pulses of the series of sequences of pulses being equal to the period (T_{1,2}; T_{1,N}) of the pulse situated at said position of any other sequence of pulses of the series of sequences of pulses, the period of each pulse of a sequence of pulses of the series of sequences of pulses being fixed in a pseudorandom manner, in a range of values such that the period of each pulse of a sequence of pulses of the series of sequences of pulses has as upper bound the inverse of 13 kHz,
the number of pulses of each sequence of pulses of the series of sequences of pulses being fixed in such a way that the inverse of the sum of the periods of all the pulses of each sequence of pulses of the series of sequences of pulses lies below the acoustic spectrum audible to a human being.

8. Computer program comprising a series of instructions which, when they are executed by a processor, implement a method according to one of Claims 1 to 6.

9. Non-transient storage medium readable by computer storing a computer program according to Claim 8.
